# EUROPEAN PATENT APPLICATION

(11) **EP 4 701 397 A2**
(43) Date of publication of application: **25.02.2026**
(21) Application number: 25192428.8
(22) Date of filing: 29.07.2025
(51) Int. Cl.: H10P 74/00

(54) **EDGE DEFECT MONITOR SYSTEM AND METHOD FOR MULTICHIP DEVICE**

(30) Priority: 31.07.2024 US 202418790597
(71) Applicant: Avago Technologies International Sales Pte. Limited, Singapore 768923 (SG)
(72) Inventor: Zhao, Sam Ziqun, Irvine, 92618 (US); Li, Xiaoming, Irvine, 92618 (US); Tsau, Liming, Irvine, 92618 (US); Tan, Teck Yang, Irvine, 92618 (US); Sharifi, Reza, Irvine, 92618 (US)
(74) Representative: Dilg, Haeusler, Schindelmann Patentanwaltsgesellschaft mbH

(57) **Abstract**

An electronic product (50) includes a number of die (100, 101A, 101B) and an interposer (52). The die (100, 101A, 101B) are coupled to the interposer (52). Each respective die (100, 101A, 101B) includes an edge integrity detection structure (163A, 163B) extending along at least part of an edge of the respective die (100, 101A, 101B). The interposer (52) includes at least one pad coupled to at least one edge integrity detection structure (163A, 163B) of the die.

## Description

### Field of the Disclosure

This disclosure generally relates to electronic products.

### Background of the Disclosure

Die edge delamination or cracking in electronic products can result in reliability problems and yield loss. Die edge delamination or cracking can occur during dicing of a wafer and can be exacerbated by the introduction of integrated circuits (ICs) with low-k dielectrics in 65 nm technology node, and beyond. The use of a low-k dielectric reduces the interconnect coupling capacitance, but also reduces mechanical strength and adhesion. Die edge delamination and cracking become even more severe when using laser grooving in the dicing process, where edge chipping can be reduced at the cost of increased thermal damage to the die edges. For example, using a laser to cut the wafer at high temperatures can cause metal to oxidize and form an enlarged metal oxidized layer. The metal oxidization can enlarge the volume of metal layer, for example, at the edges of the die. This enlarged metal oxidized layer loses strength and can peal or crack. The crack can further enter into the chip and can cause a device failure.

Electronic products can include or be multichip devices. A multichip device generally includes two or more IC die in a package. If one of one or more IC die are defective (e.g., due to edge delamination or cracking), the entire package can be defective.

### Brief Description of the Drawings

Various objects, aspects, features, and advantages of the disclosure will become more apparent and better understood by referring to the detailed description taken in conjunction with the accompanying drawings. In the drawings, like reference numbers generally indicate identical, functionally similar, and/or structurally similar elements.
FIG. 1 is a top planar view schematic drawing of an electronic product including an edge defect monitor including edge integrity detection structures according to some embodiments;
FIG. 2 is a cross-sectional view schematic drawing of a portion of an electronic including edge integrity detection structures according to some embodiments;
FIG. 3 is top planar view schematic drawing of an interposer wafer for electronic products including edge integrity detection structures according to some embodiments;
FIG. 4 is top planar view schematic drawing of an electronic product including edge integrity detection structures coupled in series according to some embodiments;
FIG. 5 is top planar view schematic drawing of an electronic product including edge integrity detection structures coupled in parallel according to some embodiments;
FIG. 6 a cross-sectional view schematic drawing of a portion of an electronic product including an edge integrity detection structure disposed on an interposer according to some embodiments; and
FIG. 7 is top planar view schematic drawing of the electronic product illustrated in FIG. 6 according to some embodiments.

### Detailed Description

Below are detailed descriptions of various concepts related to, and embodiments of, techniques, approaches, methods, apparatuses, and systems for determining if all IC dies in a multichip device are known good die (KGD). In some embodiments, systems and methods employ edge integrity detection or an edge detection monitor (EDM) to confirm that all die or chiplets in the multichip device are not damaged (e.g., do not have edge delamination or cracks). Determining whether all die are KGD before the IC package is completed advantageously saves costs because defective die can be rejected and replaced before final assembly.

In some embodiments, the systems and methods identify KGD after wafer dicing so that die damaged after dicing are not included in the final package. Placing a damaged chiplet from the chiplet wafer dicing operation into the chiplet package renders the chiplets package defective and wastes all the other KGD chiplets or tiles in the package. A chiplet or tile refers to an IC die in a multichip device in some embodiments. The chiplet or tile can be dedicated to one or more functions in the multichip device. Such functions can include but are not limited to computational processing, graphical processing, artificial intelligence (AI) engines or AI accelerators, I/O functions, wireless or wired communications or other chip functions. Multichip devices with chiplets can be more modular and customizable than systems on a chip (SoC) in some embodiments.

In some embodiments, the multichip device or chiplet package includes an interposer that receives the chiplets and enables high-density interconnections which may not be available using the printed wire board (PWB) or package substrate. Systems and methods that identify each chiplet or tile as a KGD at each process step increases overall yield of the chiplets integration interposer wafers (CIIWs) for the chiplets and the packaging yield of the CIIW assemblies (e.g., containing the chip on wafer (CoW), package substrate, and/or printed wire circuit board (PWB) for the chiplet package).

In some embodiments, systems and method screen out packaged devices having one or more edge damaged chiplets and chiplets integration interposers (CIIs). In some embodiments, each chiplet includes an edge integrity detection structure which is connected in series or in parallel with each other. In some embodiments, the chiplets are mounted on an interposer or board including an edge integrity detection structure. In some embodiments, the edge integrity detection structures on the chiplets and the interposer are connected in series or in parallel with each other.

Some embodiments relate to an electronic product. The electronic product includes a number of die and an interposer. The die are coupled to the interposer. Each respective die includes an edge integrity detection structure extending along at least part of an edge of the respective die. The interposer includes at least one pad coupled to at least one edge integrity detection structure of the die.

An electronic product can refer to any device that uses electronic signals in some embodiments. An edge integrity detection structure can refer to any structure or circuit configured for detecting a defect in an IC die or interposer (e.g., a delamination defect, cracks, an edge defect, etc.) in some embodiments. The edge integrity detection structure can be a sensing element for such defects and can be embodied as a conductive trace on one or more layers, a circuit including resistive or capacitive elements, or other IC structure. In the context of the present application, the term edge integrity detection structure may denote for example an electrically conductive physical structure positioned and/or structurally configured for detecting information indicating whether or not an edge along or around a semiconductor chip is intact or not (for instance is broken). In particular, edge integrity may be impacted by separating a semiconductor chip from a wafer by cutting or sawing along an edge of each semiconductor chip. For example, an edge of a semiconductor chip may break or delaminate during a singulation process. The edge integrity detection structure may be located along the edge or part thereof so as to be impacted by an edge separation process which causes damage of the edge. The edge integrity detection structure may act as a damage probe element for detecting an edge integrity deteriorating event. The edge integrity detection structure may include portions that are not located on the edge. The edge integrity structure can be a circuit (e.g., a one or more conductive traces or conductive traces combined with circuit elements or other IC structures). An interposer may refer to any structure that is configured to houses IC die and provide interconnections for the IC die in some embodiments. In a multichip device (MCM), an interposer is a substrate that sits between the silicon chips (or dies) and the package substrate or a main circuit board in some embodiments. A die can refer to a structure including an integrated circuit in some embodiments. For example, a die can be a chip or chiplet.

In some embodiments, the electronic product also includes circuitry disposed on at least one of the die and electrically connected with the edge integrity detection structure of each respective die. The circuitry is configured to evaluate an electric characteristic of at least one edge integrity detection structure to provide a signal indicative of integrity of the die. Integrity of a die refers to a condition of the die in some embodiments. The condition can be whether the die has a defect in some embodiments. An electrical characteristic refers to resistance, capacitance, inductance, voltage, an RC time constant, a resonance, or current in some embodiments.

Circuitry refers to one or more circuits in some embodiments. In some embodiments, the circuitry forms part of and/or is electrically connected with an integrated circuit formed in and/or on the die. In some embodiments, the circuitry is arranged at the edge of the die neighboring at least part of a seal ring. In some embodiments, circuitry is disposed on the interposer and is electrically connected with the edge integrity detection structure of each respective die. The circuitry is configured to evaluate an electric characteristic of at least one edge integrity detection structure to provide a signal indicative of integrity of the die. A multichip device (MCM) can refer to a type of electronic assembly where two or more integrated circuits (ICs) or IC die are packaged together within a single module or package.

In some embodiments, the edge integrity detection structure of each die is coupled in series with each other. In some embodiments, the edge integrity detection structure of each die is coupled in parallel with each other. In some embodiments, an interposer edge integrity detection structure is disposed on the interposer. In some embodiments, the edge integrity detection structure of each die is coupled in parallel with the interposer edge integrity detection structure. In some embodiments, the edge integrity detection structure of each die is coupled in series with the interposer edge integrity detection structure. An interposer edge integrity detection structure can refer to an edge integrity detection structure disposed on an interposer.

Some embodiments relate to a multichip device. The multichip device includes a number of IC die and an interposer. Each respective die includes an edge integrity detection structure. The IC die are disposed on a top surface of the interposer including at least one pad coupled to at least one edge integrity detection structure of the die.

In some embodiments, an inner seal ring and an outer seal ring surround at least part of each respective die, and at least part of the edge integrity detection structure is disposed between the inner seal ring and the outer seal of each respective die.. In some embodiments, each edge integrity detection structure is configured as a two terminal resistor chain. In some embodiments, the pad is disposed on a bottom surface opposite the top surface. In some embodiments, the interposer includes a redundant pad for the pad. In some embodiments, the redundant pad is disposed on the top surface.

Some embodiments relate to a method of detecting integrity in a multichip device. The method includes providing a signal to an edge integrity detection structure on each of a number of die coupled to an interposer, receiving a signal from at least one of integrity edge integrity detection structure at a pad on the interposer, and determining the integrity using the signal received at the pad.

In some embodiments, the edge integrity detection structure includes a conductive trace about a perimeter of the respective die. In some embodiments, a signal is provided to an edge integrity detection structure on the interposer, a signal is received from the edge integrity detection structure on the interposer. A conductive trace can refer to any conductor or conductive structure provided on an IC die or interposer in some embodiments. A conductive trace can be provided in one or more layers of metallization layers in some embodiments.

The various concepts introduced above and discussed in detail below can be implemented in any of numerous ways, as the described concepts are not limited to any particular manner of implementation. Examples of specific embodiments and applications are provided primarily for illustrative purposes.

IC die (e.g., chiplets) and interposers with edge assurance structures or edge integrity detection structures are provided in some embodiments. The edge integrity detection structure can be located around an edge of the integrated circuit and can be configured in a variety of patterns and structures on one or more layers of each die or interposer. The die and interposer can include a pad that is coupled to the edge integrity detection structure. The pad can be used to measure a resistance of the edge integrity detection structure.

In some embodiments, a semiconductor or electronic product is provided which includes a semiconductor chip or substrate, an integrated circuit (IC) formed in and/or on the semiconductor chip, an edge integrity detection structure extending along at least part of an edge of the semiconductor chip, and evaluation circuitry formed in and/or on the semiconductor chip. The circuitry is electrically connected with the edge integrity detection structure and is configured for evaluating an electric characteristic of the edge integrity detection structure for providing an evaluation signal indicative of a detected edge integrity status of the edge. In some embodiments, the use of the edge integrity detection structure reduces time for monitoring devices for delamination and other defects, such as, by visual inspection and/or time-consuming and inefficient manual probing.

In the context of the present application, a "semiconductor product" may, for example, comprise a physical body, component, or member, or even a device made of two or more different elements, being manufactured partially or entirely in semiconductor technology. For instance, the semiconductor product may comprise one or more semiconductor chips, in particular a naked or molded die. Also, systems on a chip (SoC), modules, chiplets or other electronic devices including one or a number of semiconductor chips may be denoted as semiconductor product or electronic product. Semiconductor products may be manufactured for example in group IV semiconductor technology (for instance in silicon technology) or in group III-V semiconductor technology (for example in gallium arsenide technology).

In the context of the present application, the term "semiconductor chip" may denote for example a substrate comprising a semiconductor material, such as silicon, and including integrated electric circuitry. For instance, a semiconductor chip may be a naked die or an encapsulated die. A semiconductor chip or die may be produced by singularizing a wafer (initially comprising a plurality of still integrally connected semiconductor chips) into individual semiconductor chips. Singulation of a semiconductor chip from a wafer compound may be accomplished, for example, by sawing, dicing, or laser cutting.

In the context of the present application, the term "integrated circuit" or IC may denote for example a number of interconnected integrated circuit elements manufactured at least partially by semiconductor processing technology. For example, such integrated circuit elements may include at least one of a transistor, a diode, a resistor, a conductive trace, a contacts, a via, a capacitor, an inductor, etc. The integrated circuit elements forming the integrated circuit can be monolithically integrated in the semiconductor chip. Hence, an integrated circuit can be a monolithically integrated circuit.

In the context of the present application, the term "planar electrically conductive layer structures" may denote for example flat patterned or structured metal layers. Each of the layer structures may extend within a horizontal plane. Different layer structures may be located in different planes, the planes being parallel to each other. The layer structures may form part of a common layer stack.

In the context of the present application, the term "evaluation circuitry" may denote for example circuitry configured for evaluating electric signals of an edge integrity detection structure for determining information about edge integrity. For example, such evaluation circuitry may comprise hardware elements. For instance, the evaluation circuitry may be hardwired. However, it is also possible that the evaluation circuitry includes software elements (for instance including firmware). The evaluation circuitry may be on-chip and for example may be monolithically integrated in the semiconductor chip of the semiconductor product. The evaluation circuitry may be remote or separate from the electronic device (e.g., may be part of test equipment) in some embodiments.

In the context of the present application, the term "evaluation signal indicative of a detected edge integrity status of the edge" may denote for example an electric signal which carries information characterizing integrity or non-integrity of an edge of the semiconductor die and or interposer. For example, the edge integrity status may indicate that integrity of the edge can be confirmed or that the edge shows non-integrity. Hence, the edge integrity status may indicate the status in a digital way, for instance by a logical value "1" or "0". It is also possible that more than two different edge integrity states may be distinguished, for instance full integrity, no integrity, limited but still acceptable integrity, and limited but no more acceptable integrity. Alternatively, the edge integrity status may be indicated by a gradual value, for instance by an analog value. The evaluation signal may be an on-chip or off-chip signal.

Generally, some embodiments of a first aspect provide semiconductor products having an edge integrity detection structure with multiple mutually overlapping interconnected planar electrically conductive layer structures. In some embodiments, such interconnected electrically conductive layer structures may be aligned with each other so that they have a common identical outline in a top view. The electrically conductive layer structures may constitute an aligned electrically conductive network or framework along an exterior edge of the semiconductor chip. When the edge of the semiconductor chip is damaged, in particular during separating the semiconductor chip from a semiconductor wafer, integrity of the edge integrity detection structure may be intentionally damaged. For example, an electric connection of constituents of the edge integrity detection structure may be damaged in the occurrence of phenomena such as breakage or delamination at the edge of the semiconductor chip or a surrounding seal ring. An evaluation of the electric characteristics of the edge integrity detection structure may then allow to derive information concerning an edge integrity status of the chip edge. Advantageously, the construction of the edge integrity detection structure from three or more interconnected planar electrically conductive layer structures in different parallel planes all overlapping with all others partially or substantially completely in a plan view may create a quasi-continuous electrically conductive wall constituting an elongate two-dimensional resistor chain. Such a structure may be highly sensitive to any kind of damage at an edge around the semiconductor chip. In particular, constructing the edge integrity detection structure from multiple interconnected planar electrically conductive layer structures being almost completely in alignment with each other in a plan view may allow to form a quasi-continuous grid-type edge damage probe being intentionally prone to damage when the edge around the semiconductor chip is damaged. A quasi-continuous electrically conductive network of interconnected layer structures may be highly sensitive with regard to substantially any kind of edge damage so that false outputs erroneously confirming edge integrity may be reliably prevented.

Moreover, some embodiments of a second aspect provide a semiconductor chip with edge integrity detection structure (for example of the above-mentioned kind or of another kind) extending along an exterior edge of an integrated circuit of the semiconductor chip and having an on-chip evaluation circuitry. In some embodiments, the evaluation circuitry may form part of the same semiconductor chip or interposer which also includes the edge integrity detection structure. Thus, an evaluation signal indicating a detected edge integrity status characterizing integrity or non-integrity of the semiconductor chip edge may be created by and on the semiconductor chip itself or on the interposer. An interposer EDM structure can be tested self-tested together with one of connected chiplet die by connecting the interposer EDM structure with the chiplet die EDM structure in some embodiments. In some embodiments, electric paths are kept short, thereby ensuring a high quality of the evaluation signal. Moreover, providing an on-chip evaluation circuitry electrically connected with an edge integrity detection structure may allow generation of an on-chip evaluation signal for indicating the detected edge integrity status. This evaluation signal may be read out during a chip test process. In some embodiments, large pads can be provided for a further processing of the evaluation signal apart from the chip. Processing of the evaluation signal apart from the chip allows a more compact semiconductor chip in some embodiments.

In some embodiments, the edge integrity detection structure is configured as a two terminal resistor chain. A first open end and a second open end of the edge integrity detection structure may be electrically coupled with each other by the electric resistance created by the electrically conductive layer structures and the vertical connection elements of the edge integrity detection structure, when intact. When the electrically conductive edge integrity detection structure is however not intact due to a damage of the semiconductor chip edge, an electrically conductive connection along the electrically conductive layer structures and the vertical connection elements will be interrupted so that the first open end and the second open end will be electrically decoupled from each other. Such a difference of the resistance of the edge integrity detection structure, when configured as two terminal resistor chain, between an intact and a damaged state may be detected electrically. In some embodiments, the two terminal resistor chain is connected between a lower supply voltage terminal (such as a ground terminal) and a sense terminal.

In some embodiments, the evaluation circuitry is electrically connected or connectable with the edge integrity detection structure and is configured for evaluating a resistance of the edge integrity detection structure for providing an evaluation signal indicative of a detected edge integrity status of the edge. The evaluation may measure the ohmic resistance of the edge integrity detection structure and may use the results of this measurement to derive information about the integrity status of the semiconductor chip or a seal ring around the semiconductor chip. For example, a measured low ohmic resistance may indicate that the edge integrity detection structure and hence the edge of the semiconductor chip are intact. In contrast to this, a measured high ohmic resistance may indicate that the edge integrity detection structure is interrupted and hence the edge of the semiconductor chip is damaged.

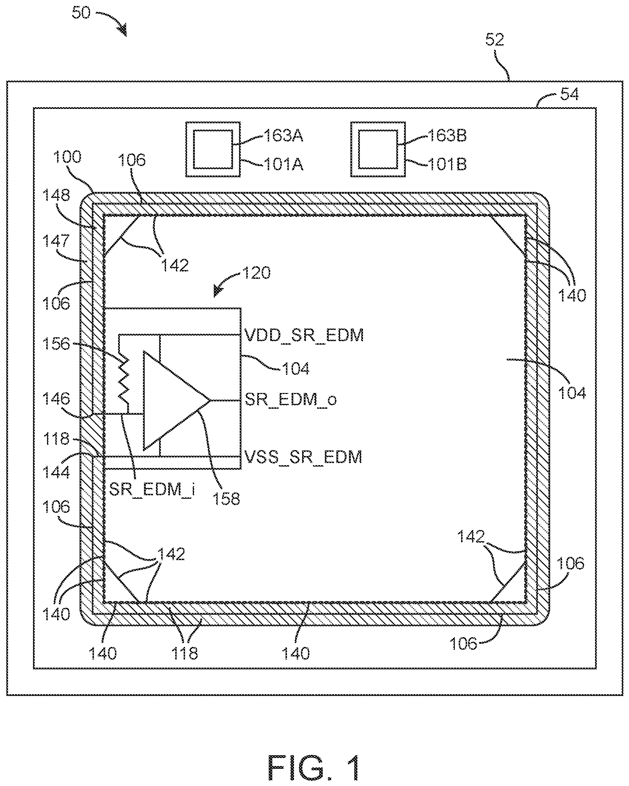

In some embodiments, the evaluation circuitry is monolithically integrated in one or more die and/or the interposer. Thus, the evaluation circuitry may be created by integrated circuit elements formed in and/or on the semiconductor chip. In particular, the evaluation circuitry may form part of the integrated circuit of the semiconductor chip. This may lead to a small space consumption and may thereby contribute to a miniaturization of the semiconductor chip. Various aspects of exemplary embodiments are described below with reference to FIGS. 1-7.

With reference to FIG. 1, an integrated circuit (IC) or electronic product 50 can be configured as a multichip device including an interposer 52 and one or more chips or IC die 100, 101A and 101B. Product 50 can include any number of die (e.g., 1 to N, where N is an integer) Die 100, 101A and 101B can be configured for various functions including but not limited to computational processing, graphical processing, AI engines or AI accelerators, I/O functions, wireless or wired communications, power control, or other chip functions. Die 101A and 101B can be similar to die 100 or be configured for unique operations from each other.

Interposer 52 is component configured for connecting to die 100, 101A, and 101B. Interposer 52 can be provided in a multichip device and act as an intermediary substrate that connects multiple integrated circuits (ICs) or die 100, 101A, and 101B within a single package to each other and to a package substrate which connects to components on a circuit board. Interposer 52 includes connections and conductive traces between the die 100, 101A, and 101B for power, communication, and data transfer. Interposer 52 routes signals between die 100, 101A, and 101B and external package connections. In some embodiments, interposer 52 is configured to optimize signal integrity and reduce latency.

Interposer 52 can be made from a variety of materials and include multiple conductive or metal layers. Materials for interposer 52 include but are not limited to silicon with through-silicon vias (TSVs) to provide vertical electrical connections, organic materials, glass materials, and metallization layers. In some embodiments, interposer 52 can reduce the distance between die 100, 101A, and 101B using high-density interconnects and can enhanced integration of different types of die 100, 101A, and 101B (e.g., logic, memory, analog) in a single package, leading to more compact and efficient designs. In some embodiments, interposer 52 can provide thermal management by spreading heat more effectively across the module. Interposer 52 can utilize connections including but not limited to pins, pads, TSVs, micro bumps, and fine-pitch bonding.

The semiconductor chip or IC die 100 may include a semiconductor substrate, such as a silicon substrate. Furthermore, an integrated circuit 104 (only shown schematically) may be formed in and/or on the IC die 100. In particular, the integrated circuit 104 may be monolithically integrated in the IC die 100. The integrated circuit 104 may comprise a number of integrated circuit elements, such as at least one of a transistor, a diode, a resistor, a conductive trace, a contacts, a via, a capacitor, or an inductor. Advantageously, the integrated circuit 104 may be formed in a central portion (e.g., away from edges) of the IC die 100. The integrated circuit 104 may provide or may contribute to a functional application of the die 100. For example, the die 100 may be configured for providing a Wi-Fi application, a Bluetooth application, a video application, an audio application, a mobile phone application, and/or an automotive application. Many other and/or different functional applications are possible.

Reference sign 140 illustrates a boundary of the IC die 100. Reference sign 142 shows a place and route boundary (prBoundary). A seal ring 118 surrounds the IC die 100 and its integrated circuit 104. The seal ring 118 may be a metallic structure which protects the IC die 100 to prevent chipping and cracking. The seal ring 118 may form part of the IC die 100 or may be arranged to surround the IC die 100.

An edge integrity detection structure 106 is provided to extend along a major portion of an edge of the IC die 100. Although Fig. 1 shows an example of structure 106 located outside die place and route boundary 142, structure 106 can also be within boundary 142. In some embodiments, the edge integrity detection structure 106 may extend along almost the entire perimeter of the IC die 100 (for above 80 percent (e.g., above 90 percent, 95 percent or more than 100 percent of the length of the perimeter). In some embodiments, the edge integrity detection structure 106 extends along the entire perimeter except for a short path between a first terminal 144 and a second terminal 146 of the edge integrity detection structure 106. The edge integrity detection structure 106 allows integrity of an edge of or around the IC die 100 to be detected using an electric detection of a signal between the first terminal 144 and the second terminal 146, as will be described below in further detail. The actual gap between the two terminals 144 and 146 is in the order of one tenth of a micron or smaller in some embodiments (e.g., for certain modern semiconductor chips). The gap seen on FIG. 1 is not to scale.

In some embodiments, the edge integrity detection structure 106 is integrated in the seal ring 118. Each of die 101A and 101B and interposer 52 can include a similar edge integrity system to that described above for IC die 100. In some embodiments, structure 54 of interposer 52 and structures 163A and 163B of die 101A and 101B are connected in series and/or parallel with structure 106.

With reference to FIG. 1, a first portion 147 of the seal ring 118 is provided at an exterior position from the edge integrity detection structure 106, whereas a second portion 148 of the seal ring 118 is arranged at an interior position from the edge integrity detection structure 106. By integrating the edge integrity detection structure 106 into the seal ring 118, a compact configuration of the die 100 may be obtained. First portion 147 of the seal ring 118 is an outer seal ring portion. A gap for creating edge integrity detection structure 106 is between first portion 147 and structure 106 and between second portion 148. Second portion 148 is an inner seal ring portion. A seal ring buffer area is a buffer or transition zone provided on an interior side of second portion 148.

In some embodiments, interposer 52 and each of IC die 100, 101A and 101B are configured to provide edge integrity detection (e.g., by using edge integrity structures such as edge integrity detection structures 106, 54, 163A and 163B) as described below. The description of edge integrity monitoring for IC die 100 above and below applies to IC die 101A and 101B, and interposer 52 in some embodiments. The edge integrity detection structures 106, 54, 163A and 163B can include a number of electrically connected planar electrically conductive layer structures in some embodiments. In some embodiments, electrically conductive vertical connection elements electrically connect neighboring electrically conductive layer structures. The vertical connection elements are conductive (e.g., metallic (e.g., copper, copper alloy, aluminum, aluminum alloy, or other metal)) vias in some embodiments. Overlapping or aligned arrangement of the electrically conductive layer structures at different vertical levels of the edge integrity detection structures 106, 54, 163A and 163B has advantages. By almost completely covering a two-dimensional area defining the edge integrity detection structures 106, 54, 163A and 163B, the provided resistor chains are sensitive to potential damages along almost the entire edge of interposer 52, IC die 100, 101A, and 101B. If the damage occurs at a respective position of the edge, the continuous resistor chain formed is interrupted, and a strong increase of the resistance of the edge integrity detection structures 106, 54, 163A and 163B can be detected by evaluation circuit 120.

The edge integrity detection structures 106, 54, 163A and 163B may be configured as two terminal resistor chains connected to evaluation circuit 120. The structures 106, 54, 163A and 163B form a resistor chain between the first terminal 144 and the second terminal 146. The two terminal resistor chain can be connected between the first terminal 144, constituting a lower supply voltage terminal VSS_SR_EDM (such as a ground terminal), and the second terminal 146 functioning as a sense terminal SR_EDM_i. Moreover, the sense terminal SR_EDM_i may be coupled via a pull-up resistor 156 of a pull-up circuitry to a supply voltage VDD_SR_EDM.

The denotations VSS_SR_EDM, VDD_SR_EDM, SR_EDM_i, SR_EDM_o are defined as follows: "VSS" indicates a lower supply potential (such as ground), "VDD" indicates a higher supply potential (for providing electric operation energy), "SR" indicates a reference to seal ring 118, "EDM" relates to an edge damage monitor ring (corresponding to edge integrity detection structure 106), "i" denotes input, and "o" denotes output.

Still referring to FIG. 1, evaluation circuit 120 may be electrically connected with the edge integrity detection structure 106 via the first terminal 144 and the second terminal 146. In some embodiments, evaluation circuit 120 comprises a logic block 158 which is configured for evaluating a resistance of the edge integrity detection structure 106 for providing an evaluation signal at an output terminal SR_EDM_o indicative of a detected edge integrity status of the edge of the IC die 100. Logic block 158 can be in each of die 101A and 101B or in interposer 52 in some embodiments. In some embodiments, one logic block 158 on one of die 100, 101A, and 101B or interposer 52 performs monitoring operations for the entire multichip device or product 50 Alternatively, a logic block 158 is not included with multichip device or product 50.

Advantageously, the evaluation circuit 120 may be monolithically integrated in interposer 52 and/or IC die 100, 101A, and/or 101B or may be a remote circuit. The evaluation circuit 120 may be formed in and/or on the IC die 100 in some embodiments. This may keep the dimensions of the semiconductor product 50 small. Furthermore, short connection paths between edge integrity detection structure 106 and evaluation circuit 120 may then be ensured, which may have a positive impact on quality and integrity of the evaluation signal. Furthermore, the evaluation circuit 120 forms part of or is electrically connected with the integrated circuit 104. Thus, the evaluation signal may be transported to the integrated circuit 104 so that it can be provided for further processing during a chip test or the like. Monolithically integrating the evaluation circuit 120 also into the IC die 100 may also contribute to a miniature or smaller design.

According to FIG. 1, the evaluation circuit 120 is arranged at an edge of the integrated circuit 104 neighboring to the seal ring 118 on a left-hand side of the IC die 100. However, it is alternatively possible that the evaluation circuit 120 is located on a right-hand side, on a top side and/or on a bottom side of the IC die 100. Hence, the circuitry according to FIG. 1 can be freely designed.

As already mentioned, the evaluation circuit 120 may be electrically connected with the edge integrity detection structure 106 and/or one or more of edge integrity detection structures 163A, 163B and 54. Furthermore, evaluation circuit 120 may be configured for evaluating an electric characteristic of the edge integrity detection structure 106 for providing an evaluation signal indicative of a detected edge integrity status of the edge of the IC die 100. More specifically, the evaluation circuit 120 may be configured for evaluating a resistance of the edge integrity detection structure 106 and/or one or more of edge integrity detection structures 163A, 163B and 54 as basis for the evaluation signal. For example, evaluation of the resistance may be accomplished by detecting a current flowing through the edge integrity detection structure 106 106 and/or one or more of edge integrity detection structures 163A, 163B and 54. For instance, a zero current may be indicative of a defective detected edge integrity status, since an interruption of the resistor chain formed by the layer structures and the vertical connection elements may increase the resistance to an extremely high value. Furthermore, a non-zero current flowing along edge integrity detection structure 106 and/or one or more of edge integrity detection structures 163A, 163B and 54 may be indicative of an intact detected edge integrity status since a current may flow only along an intact resistor chain.

Advantageously, the evaluation circuit 120 of FIG. 1 can be configured for providing a logic evaluation signal indicative of the detected edge integrity status and supplied at terminal SR_EDM_o. The logic or digital evaluation signal is preferably a one-bit signal indicating by a logic value "0" or "1" whether or not the edge integrity detection structure 106, and consequently the edge of the IC die 100, 101A, 101B is intact or not. In order to create such a logic digital evaluation signal, the evaluation circuit 120 may comprise an analog block for detecting information indicative of a resistance of the edge integrity detection structure 106. Furthermore, the evaluation circuit 120 may be configured for providing, at terminal SR_EDM_o, the digital evaluation signal indicative of the detected edge integrity status. The terminal SR_EDM_o may function as an electric output interface configured for providing the evaluation signal to an external automatic test equipment (not shown). For instance, the evaluation circuit 120 may provide the evaluation signal in the framework of a semiconductor product test procedure.

Evaluation circuit 120 can be any hardware circuit or software process for detecting structure integrity. In some embodiments, evaluation circuit 120 is processor, microcontroller (e.g., executing firmware), an ASIC, a field programmable gate array (FPGA) or logic device, or any other type and form of dedicated semiconductor logic or processing circuitry capable of processing or supporting the operations described herein.

The illustrated evaluation circuit 120 includes a reference resistance structure having a higher resistance value than the edge integrity detection structure 106 in an intact state of the edge integrity detection structure 106. The evaluation circuit 120 includes a comparator circuit 124. Comparator circuit 124 is configured for comparing a signal indicative of the resistance value of the edge integrity detection structure 106 and/or one or more of edge integrity detection structures 163A, 163B and 54 with a signal indicative of the resistance value of the reference resistance structure. As a result, the evaluation signal provided by comparator circuit 124 may be provided as an output of the comparator circuit 124. In some embodiments, the evaluation circuit 120 includes bias circuitry for electrically biasing the edge integrity detection structure 106 and the reference resistance structure.

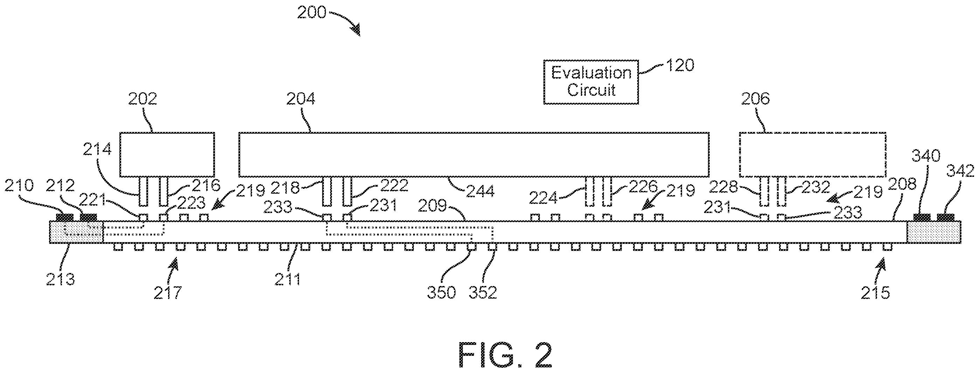

With reference to FIG. 2, a multichip device 200 is similar to product 50 (FIG. 1). Module 200 includes an interposer 208 configured as a chiplet-to-chiplet integration interposer (CII) and one or more IC die or chiplets 202, 204, and 206. Module 200 can include any number of die (e.g., 1 to N, where N is an integer). Chiplets 202, 204, and 206 can be configured for various functions including but not limited to computational processing, graphical processing, AI engines or AI accelerators, I/O functions, power operations, wireless or wired communications or other chip functions. For example, chiplet 202 can be a main central processing unit, and chiplets 202 and 206 can be memory units, I/O units, etc.

Chiplets 202, 204, and 206 are provided between saw-street or scribe lines 213 and 215. Terminals or pads 210 and 212 can be located in scribe line 213, and terminals or pads 340 and 342 can be locates in scribe line 215. A wafer scribe line, also known as a scribe street or kerf, is a narrow space or line on a semiconductor wafer that separates individual die or chips. These lines or areas are intentionally designed and left empty to facilitate the cutting or dicing of the wafer into interposers during the manufacturing process. The width of the scribe lines can be 1x ~ 4x multiples of 80um or wider (e.g., wider for interposer 208) in some embodiments.

Terminals or pads refer to bond pads or connectors in some embodiments. Terminals or pads are generally small, conductive areas on an IC die, interposer, or other circuit that serve as connection points for electrical contacts. Pads can provide permanent or temporary points where wires, probes, pins, solder bumps, or other conductive materials can be attached to create electrical connections between the IC die, interposer, package leads, printed circuit board (PCB), or external components. Terminals or pads can be formed of any conducting material which provides good electrical conductivity, including but not limited to metal such as aluminum, gold, silver, copper, or alloys thereof, and is compatible with common wire bonding or soldering processes in some embodiments. Terminals and pads can include microbumps or other structures for facilitating connections. Terminals or pads can be any size including the size of an entire metallization layer.

Interposer 208 is a component configured for connecting and housing chiplets 202, 204, and 206. Interposer 208 is similar to interposer 52 in some embodiments. Interposer 208 includes a top main surface 209 and an opposite bottom main surface 211. Bottom surface 211 includes pads 217 for connection to a package substrate in some embodiments. Top surface 209 includes pads 219 for connection to chiplets 202, 204, and 206 in some embodiments.

In some embodiments, chiplet 202 includes an edge detection structure (e.g., similar to structure 106) coupled to terminals, pins, or pads 214 and 216 which can be coupled to terminals or pads 221 and 223 of interposer 208. Pads 221 and 223 are coupled to pads 210 and 212 via conductors in metallization layers of interposer 208. In some embodiments, chiplet 206 includes an edge detection structure (e.g., similar to structure 106) coupled to terminals, pins, or pads 228 and 232 which can be coupled to terminals or pads 231 and 233 of interposer 208. Pads 231 and 233 are coupled to pads 210 and 212 or pads 340 and 342 via conductors in metallization layers of interposer 208. In some embodiments, chiplet 204 includes an edge detection structure (e.g., similar to structure 106) coupled to terminals, pins, or pads 218 and 222 which can be coupled to terminals or pads 235 and 237 of interposer 208. Pads 235 and 237 are coupled to pads 210 and 212, 340 and 342, or terminals or pads 350 and 352 via conductors in metallization layers of interposer 208. Pads 350 and 352 are on bottom surface 211 of interposer 208 in some embodiments. In some embodiments, edge integrity detection structure of each die or chiplet 202, 204, and 206 are not connected with each other and are coupled through interposer 208 to corresponding terminals on the package substrate for individual testing of chiplets 202, 204, and 206.

Pads 214, 216, 218, 228, and 232 are coupled in series in some embodiments. Pads 214, 216,218, 228, and 232 are coupled in parallel in some embodiments. In some embodiments, at least one of pads 210, 212, 214, 216, 218, 228, 232, 340, and/or 342 is coupled to an edge detection integrity monitor or evaluation circuit 120. Pads 214, 216, 218, 228, and 232 can be coupled to an internal or external evaluation circuit 120 through test probes, programmable connection, or permanent connections in some embodiments. In some embodiments, pads 210, 212, 340, and/or 342 are coupled to an edge detection structure on interposer 208. Each edge detection structure of chiplets 204, 206, and 208 and interposer 208 can be a conductor disposed about the periphery of each of chiplets 204, 206, and 208 and interposer 208.

In some embodiments, at least one of chiplets 202, 204, and 206 has at least two (2) EDM terminals (an EDM sense pin and an EDM power pin, e.g., as pads 214, 218, 222, 224, 226, 228, or 232). Chiplets 202, 204, 206 and/or interposer 208 can contain EDM circuitry that has at least two terminals/EDM pins or pads 214, 218, 222, 224, 226, 228, or 232 among the chiplet external terminals or pads for I/O, power, and ground on the chiplet front side (micro bump side or side 244). In some embodiments, chiplets 202, 204, and 206 can contain redundant EDM power and/or sense pins (more than one pair of EDM terminals such as 1 EDM sense + 2 EDM power, 2 EDM sense + 2 EDM power, etc.) to (i) minimize false rejects caused by contact resistance between the probe card pins and the chiplet EDM pins during EDM testing of individual chiplets 202, 204, and/or 208 before assembly onto CIIW wafer for interposer 208 and (ii) allow at least one EDM interconnect interface failure between the chiplet and the CIIW. For example, pads 218 , 222, 224, and 226 can be redundant pads or pins for EDM signals. In some embodiments, the EDM power pin can be a dedicated EDM power pin, a shared analog power pin, or a shared core/digital power pin.

In some embodiments, interposer 208 is configured as a chiplets integration interposer and has at least two (2) or more EDM pad(s) (e.g., an EDM signal pad and EDM power pad) (e.g., pads 340 and 342). Pins or pads 218 and 222 and pins or pads 224 and 226 correspond to EDM terminals/pins of chiplet 204 in some embodiments. Pads 210, 221, 340 and 340 are located on top surface 209 in some embodiments.

Pads 210 and 212 and pads 340 and 342 can be redundant wafer after test pads disposed on surface 209. Pads 210 and 212 and pads 340 and 342 have electrical interconnections with at least one pair interfacing with chiplets 202, 204, and/or 208. In some embodiments, pads 350 and 352 are configured backside (C4 bump side) pads (e.g., an EDM signal bump and an EDM power bump).

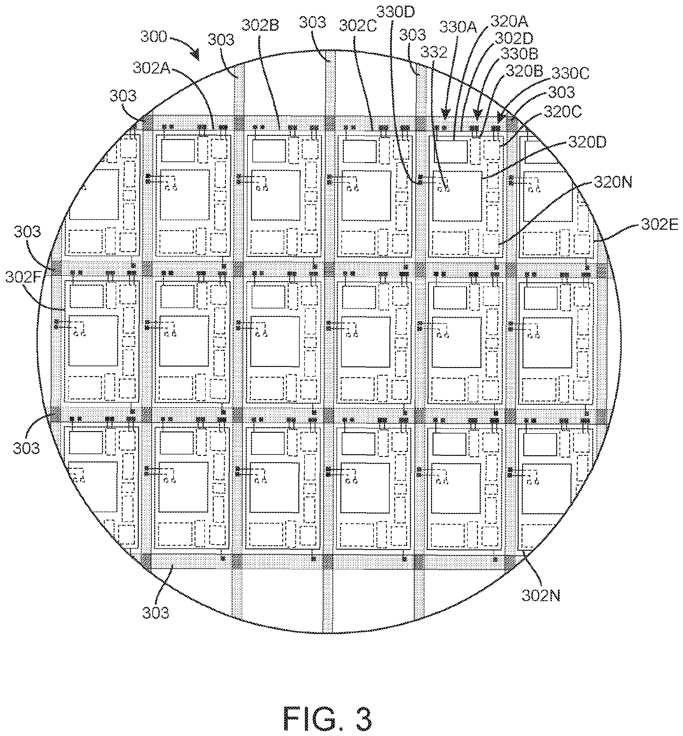

With reference to FIG. 3, multichip device 200 (FIG. 2) can be provided using a wafer 300 including a number of interposers 302A-N separated by scribe lines 303. The number of interposers 302A-N can be any number from 1 to N, where N is an integer. Each of interposers 302A-N can be similar to interposer 208. Interposers 302A-N are shown before cutting along scribe lines 303.

Each of interposers 302A-N can include multiple chiplets similar to interposer 302D. For example, interposer 302D includes chiplets 320A, 320B, 320C, and 320D. Interposer 302D can include fewer or more chiplets in some embodiments. Interposer 302D includes terminals or pads 330D configured as pairs of the EDM pads (interfacing with EDM pins 332 (e.g., pads 218 and 222 (FIG. 2))). Pads 330A-D are connected to a pair of wafer acceptance test (WAT) terminals (e.g., WAT EDM power pad and WAT EDM signal pad on the front side of the CIIW) and can correspond to terminals or pads 210, 212, 340 and 342 in FIG. 2) in some embodiments. Pads 330A-D allow individual testing of chiplets 320A-D through probing of the WAT in some embodiments. In some embodiments, chiplets 320A-D are EDM tested before all chiplets 320A-D are assembled onto interposer 302D in the CIIW. Each pair of pads 330A-D (interfacing with EDM pins for chiplets 320A-D) are connected to a respective pair of EDM power bump and EDM signal bump on the backside of wafer 300. The respective pair of EDM power bump and EDM signal bump on the backside of wafer 300 enable independent testing of each chiplet 320A-D for EDM by probing the EDM bumps on the backside of the wafer 300 in some embodiments.

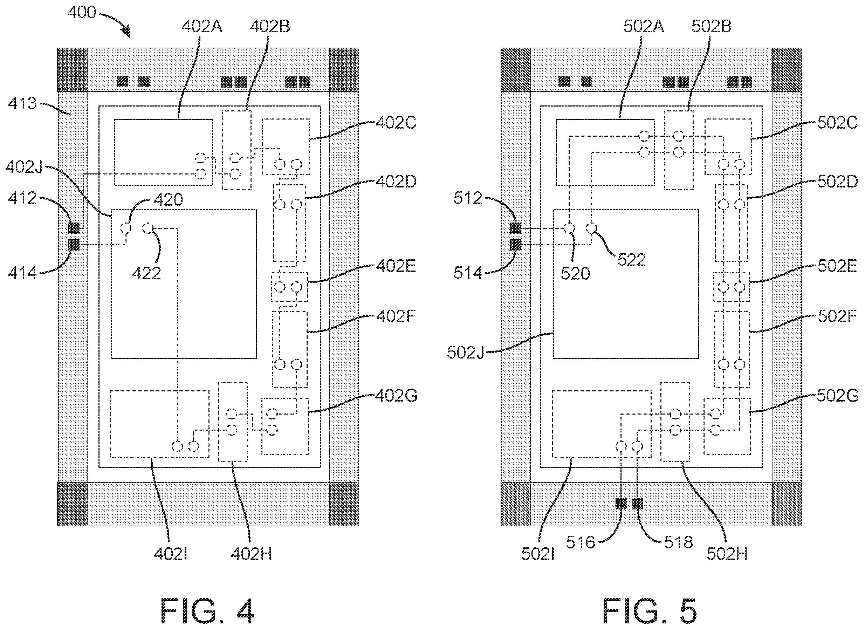

With reference to FIG. 4, an interposer 400 is configured for EDM circuitry interconnections as a CII. Interposer 400 includes chiplets 402A-J. Interposer 400 can include fewer or more chiplets in some embodiments. Interposer 400 includes terminals, pins, or pads 412 and 414 configured as a pair of EDM pads (interfacing with EDM pins 420 and 422 of chiplet 402J). The edge detection structure for each of chiplets 402A-J is coupled in series between terminals or pads 412 and 414. The edge detection structure for each chiplet 402A-J is coupled between the respective EDM pins for each chiplet 402A-J The sequential serial connection of the edge detection structures allows pad 412 in the front side of the wafer for interposer 400 and in scribe lines 413 to be used for EDM testing of all chiplets 402A-I within the serial chain. The serial chain can go from pad 414 through the edge detection structure of chiplet 402J through the edge detection structure of each of chiplets 402I-A successively to pad 412. A lower layer can be used to connect the serial chain which can also be connected to the EDM bumps on the backside of the wafer for interposer 400 and used for EDM testing of all chiplets 402A-J within the serial chain. Edge damage on one or more of chiplets 402A-J is detected if the serial EDM chain resistance is substantially increased (e.g., 10x or more than the sum of all resistances of the edge detection structures for chiplets 402A-J) in some embodiments.

With reference to FIG. 5, an interposer 500 is similar to interposer 400 and is configured for EDM circuitry interconnections as a CII. Interposer 500 includes chiplets 502A-J. Interposer 500 can include fewer or more chiplets in some embodiments. Interposer 500 includes terminals or pads 512 and 514 configured as a pair of EDM pads (interfacing with EDM pins or pads 520 and 522 of chiplet 502J). The edge detection structure for each of chiplets 502A-J is coupled in parallel between terminals or pads 512 and 514. Pins or pads 520 and 522 are coupled in parallel with each edge detection structure in chiplets 502A-J. The resistance between pads before dicing and after dicing can be determined and compared. Different values indicate damage occurred to one or more of the chiplets 502A-J during dicing in some embodiments.

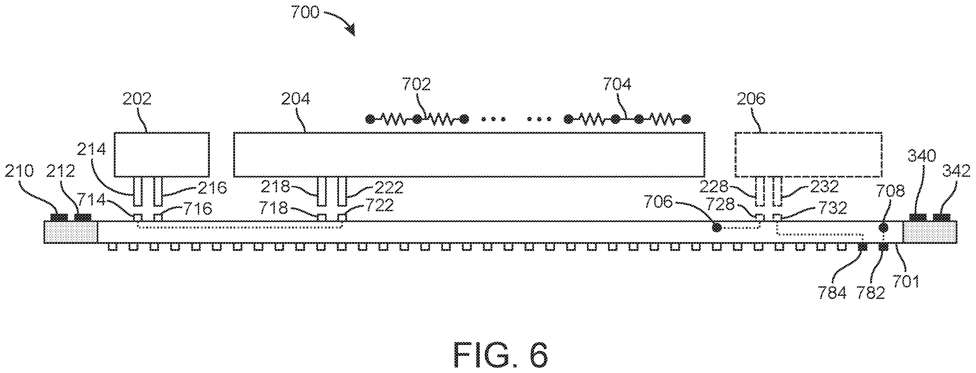

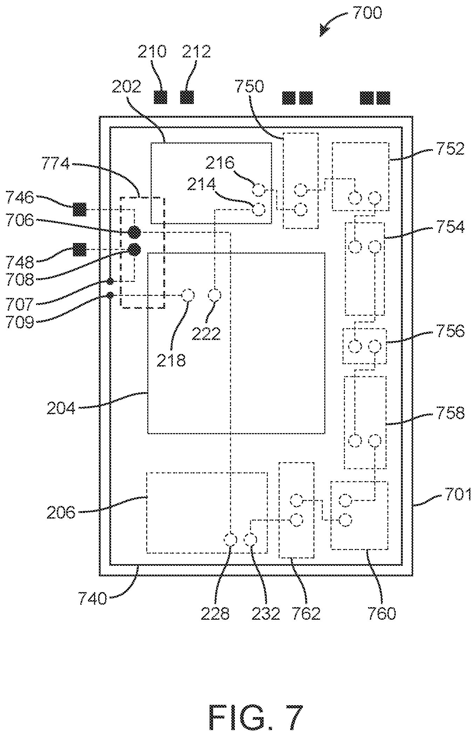

With reference to FIGS. 6 and 7, an electronic product embodied as a multichip device 700 includes an interposer 701 housing chiplets 202, 204, and 206. Interposer 701 can also include chiplets 752, 754, 756, 758, 760, and 762 (FIG. 7). Interposer 701 includes an edge integrity detection structure 740 disposed about a perimeter containing chiplets 202, 204, 206, 752, 754, 756, 758, 760, and 762 in some embodiments. The edge integrity detection structure 740 includes a conductive trace disposed in some embodiments. The conducive trace can have resistive properties in some embodiments. Edge integrity detection structure 740 can be provided in a scribe line or in the seal ring of interposer 701 in some embodiments.

Interposer 701 is embodied as CII, and the edge integrity detection structure 740 (FIG. 7) is at least one chain of continuous metal traces and vias for an EDM in some embodiments. Edge integrity detection structure 740 can be provided along the edges of interposer 701 across all conductor layers using the same structure(s) to those disclosed in U.S. Patent No. 9,741,667, incorporated herein by reference. Edge integrity detection structure 740 includes metal traces and vias in metallization layers of interposer 701 within the inner seal-ring of CII and/or in-between inner and outer seal-rings in some embodiments. Edge integrity structure includes nodes 707 and 709 that serve as EDM signals nodes (e.g., an EDM signal node and EDM power nodes). Pads 706 and 708 can be coupled with terminals or pads 746 and 748. In some embodiments, node 707 is directly coupled with pad 708 and node 709 is directly coupled with pad 706 for a parallel connection configuration. In the parallel configuration, the edge detection structures of chiplets 202, 204, 206, 752, 754, 756, 758, 760, and 762 can be coupled in parallel or serially. In some embodiments, node 707 is directly coupled with pad 708 and node 709 is coupled through serially connected edge detection structures of chiplets 202, 204, 206, 752, 754, 756, 758, 760, and 762 to pad 706 for a serial connection configuration.

A circuit 774 can include fuses or a programmable switches and can be used to make connections for the serial or parallel configurations. The serial and/or parallel configurations can be used for edge defect monitoring of interposer 701 and all of chiplets 202, 204, 206, 752, 754, 756, 758, 760, and 762 in some embodiments. The configurations can use the connections described above with respect to FIGS. 4 and 5 in some embodiments.

In some embodiments, at least one of pads 706 or 708 can be configured to connect with at least one of pads 718 or 722 (FIG. 6) of chiplet 204 (or other pads for an edge detection structure on other chiplets 202, 206, 752, 754, 756, 758, 760, and 762). Pads 718 and 722 are on a front side of interposer 701 for interfacing with pins or pads 218 and 222. Pads 714 and 716 associated with pins or pads 214 and 216 and pads 728 (FIG. 6) and 732 associated with pins or pads 228 and 232 can also be utilized. In the serial configuration, pad 708 can be coupled to a terminal or pad 782 (FIG. 6) on a back side of interposer 701, and pad 706 is couple to a terminal or pad 784 in some embodiments. In some embodiments, at least one of the nodes 707 and 709 can be configured to connect with at least one of EDM bumps on the back side of interposer 701 which is for coupling to the package substrate.

In some embodiments, edge integrity detection structure 740 is coupled in parallel with each of the structures in chiplets 202, 204, 206, 752, 754, 756, 758, 760, and 762 or in parallel with a series chain of each of the structures in chiplets 202, 204, 206, 753, 754, 756, 758, 760, and 762. In some embodiments, edge integrity detection structure 740 is coupled in series with each of the structures in chiplets 202, 204, 206, 752, 754, 756, 758, 760, and 762 in a parallel configuration or in series with a series chain of each of the structures in chiplets 202, 204, 206, 753, 754, 756, 758, 760, and 762.

In some embodiments, edge integrity detection structure 740 and each of the structures in chiplets 202, 204, 206, 752, 754, 756, 758, 760, and 762 is a circuit (e.g., a conductive trace or a combination of IC structures (e.g., resistor, diodes, capacitors, etc.) that has a resistance value 702, 704, etc. The values can each be the same or each be unique. If unique values are used, a location (chiplet identification) of the defect can be determined by monitoring the measurement of resistance in a parallel configuration. For example, if a parallel branch has an open circuit, the resistance value for the parallel network will change according to the removal of the resistance of that branch. In some embodiments, capacitance and other electrical characteristics can be considered to determine a defect location (e.g., which of chiplets 202, 204, 206, 752, 754, 756, 758, 760, and 762 or interposer 701 contains the defect).

In some embodiments, electrostatic discharge (ESD) circuits are configured to provide protection from sudden and potentially damaging discharge of static electricity in some embodiments. An ESD circuit can refer any circuit for providing ESD protection and can use diodes (e.g., transient thermal suppression diode, Schottky diodes, etc.), transistors, resistors, capacitors, clamp circuits, etc. in some embodiments. The ESD circuits can refer to any circuit configured to prevent damage that can occur when a high voltage static charge is rapidly transferred to a die, which can lead to die malfunction or failure. The ESD circuits can be coupled to pads connected to the edge integrity detection structure 740 and each of the structures in chiplets 202, 204, 206, 752, 754, 756, 758, 760, and 762.

Many modifications of the described embodiments are possible. For example, the interconnections between pads shown in the FIGS. is exemplary and can be modified depending on system criteria and operational parameters. It should be noted that certain passages of this disclosure may reference terms such as "first" and "second" in connection with devices, mode of operation, chains, etc., for purposes of identifying or differentiating one from another or from others. These terms are not intended to merely relate entities (for instance, a first device and a second device) temporally or according to a sequence, although in some cases, these entities may include such a relationship. Nor do these terms limit the number of possible entities (for instance, devices) that may operate within a system or environment.

While the foregoing written description of the methods and systems enables one of ordinary skill to make and use what is considered presently to be the best mode thereof, those of ordinary skill will understand and appreciate the existence of variations, combinations, and equivalents of the specific embodiment, method, and examples herein. The present methods and systems should therefore not be limited by the above-described embodiments, methods, and examples, but by all embodiments and methods within the scope and spirit of the disclosure.

Having now described some illustrative embodiments, it is apparent that the foregoing is illustrative and not limiting, having been presented by way of example. In particular, although many of the examples presented herein involve specific combinations of method acts or system elements, those acts and those elements can be combined in other ways to accomplish the same objectives. Acts, elements, and features discussed only in connection with one implementation are not intended to be excluded from a similar role in other embodiments or embodiments.

The phraseology and terminology used herein is for the purpose of description and should not be regarded as limiting. The use of "including" "comprising" "having" "containing" "involving" "characterized by" "characterized in that" and variations thereof herein, is meant to encompass the items listed thereafter, equivalents thereof, and additional items, as well as alternate embodiments comprising the items listed thereafter exclusively. In one implementation, the systems and methods described herein consist of one, each combination of more than one, or all of the described elements, acts, or components.

Any references to embodiments or elements or acts of the systems and methods herein referred to in the singular can also embrace embodiments including a plurality of these elements, and any references in plural to any implementation or element or act herein can also embrace embodiments including only a single element. References in the singular or plural form are not intended to limit the presently disclosed systems or methods, their components, acts, or elements to single or plural configurations. References to any act or element being based on any information, act or element can include embodiments where the act or element is based at least in part on any information, act, or element.

Any implementation disclosed herein can be combined with any other implementation, and references to "an implementation," "some embodiments," "an alternate implementation," "various implementation," "one implementation" or the like are not necessarily mutually exclusive and are intended to indicate that a particular feature, structure, or characteristic described in connection with the implementation can be included in at least one implementation. Such terms as used herein are not necessarily all referring to the same implementation. Any implementation can be combined with any other implementation, inclusively or exclusively, in any manner consistent with the aspects and embodiments disclosed herein.

References to "or" can be construed as inclusive so that any terms described using "or" can indicate any of a single, more than one, and all of the described terms. Circuitry or circuit may refer to any electronic circuit or combination of circuits. To the extent that a device, circuit, processor or circuitry is described or recited in a claims as performing one or more operations or functions or as configured to perform to one or more operations or functions, the performance of the recited function(s) or operation(s) can be distributed across two or more devices, circuits, or processors without departing from the scope of the claims unless those functions or operations are explicitly recited as being performed on a specific single circuit or set of circuits, processor, or device (e.g., using the phrase "on a single circuit", "on the set of circuits comprising" or "on a single device").

Where technical features in the drawings, detailed description or any claim are followed by reference signs, the reference signs have been included for the sole purpose of increasing the intelligibility of the drawings, detailed description, and claims. Accordingly, neither the reference signs nor their absence have any limiting effect on the scope of any claim elements.

The systems and methods described herein can be embodied in other specific forms without departing from the characteristics thereof. The foregoing embodiments are illustrative rather than limiting of the described systems and methods. The scope of the systems and methods described herein can thus be indicated by the appended claims, rather than the foregoing description, and changes that come within the meaning and range of equivalency of the claims are embraced therein.

## Claims

1. An electronic product (50), comprising:
a plurality of die (100, 101A, 101B); and
an interposer (52), wherein the die (100, 101A, 101B) are coupled to the interposer (52), wherein each respective die (100, 101A, 101B) comprises an edge integrity detection structure (163A, 163B) extending along at least part of an edge of the respective die (100, 101A, 101B), wherein the interposer (52) comprises at least one pad coupled to at least one edge integrity detection structure (163A, 163B) of the die (100, 101A, 101B).

2. The electronic product (50) according to claim 1, further comprising circuitry disposed on at least one of the die (100, 101A, 101B) and being electrically connected with the edge integrity detection structure (163A, 163B) of each respective die (100, 101A, 101B), and being configured to evaluate an electric characteristic of at least one edge integrity detection structure (163A, 163B) to provide a signal indicative of integrity of the die (100, 101A, 101B).

3. The electronic product (50) according to claim 2, comprising at least one of the following features:
wherein the circuitry forms part of and/or is electrically connected with an integrated circuit formed in and/or on the die (100, 101A, 101B);
wherein the circuitry is arranged at the edge of the die (100, 101A, 101B) neighboring at least part of a seal ring (118).

4. The electronic product (50) according to any of claims 1 to 3, further comprising circuitry disposed on the interposer (52) and being electrically connected with the edge integrity detection structure (163A, 163B) of each respective die (100, 101A, 101B), and being configured to evaluate an electric characteristic of at least one edge integrity detection structure (163A, 163B) to provide a signal indicative of integrity of the die (100, 101A, 101B).

5. The electronic product (50) according to any of claims 1 to 4, comprising at least one of the following features:
wherein the edge integrity detection structure (163A, 163B) of each die (100, 101A, 101B) are not connected with each other and are coupled through the interposer (52) to corresponding terminals on the package substrate for individual testing;
further comprising:
an interposer edge integrity detection structure (54) disposed on the interposer (52), wherein the edge integrity detection structure (163A, 163B) of each die (100, 101A, 101B) is coupled in series with each other;
wherein the edge integrity detection structure (163A, 163B) of each die (100, 101A, 101B) is coupled in parallel with each other.

6. The electronic product (50) according to any of claims 1 to 5, further comprising:
a package substrate, wherein the package substrate comprises at least one pad coupled to at least one edge integrity detection structure (163A, 163B) of at least one die of the die (100, 101A, 101B).

7. The electronic product (50) according to claim 6, comprising at least one of the following features:
wherein the edge integrity detection structure (163A, 163B) of each die (100, 101A, 101B) is coupled in parallel with the interposer edge integrity detection structure (54);
wherein the edge integrity detection structure (163A, 163B) of each die (100, 101A, 101B) is coupled in series with the interposer edge integrity detection structure (54).

8. A multichip device, comprising
a plurality of IC die (100, 101A, 101B), wherein each respective die (100, 101A, 101B) comprises an edge integrity detection structure (163A, 163B); and
an interposer (52) wherein the plurality of IC die (100, 101A, 101B) are disposed on a top surface of the interposer (52), wherein the interposer (52) comprises at least one pad coupled to at least one edge integrity detection structure (163A, 163B) of the die.

9. The multichip device according to claim 8, further comprising an inner seal ring and an outer seal ring surrounding at least part of each respective die (100, 101A, 101B), and at least part of the edge integrity detection structure (163A, 163B) is disposed between the inner seal ring and the outer seal of each respective die (100, 101A, 101B).

10. The multichip device according to claim 8 or 9, wherein each edge integrity detection structure (163A, 163B) is configured as a two terminal resistor chain and is coupled to an electrostatic discharge circuit.

11. The multichip device according to any of claims 8 to 10, wherein the pad is disposed on a bottom surface opposite the top surface.

12. The multichip device according to claim 10 or 11, wherein the interposer (52) comprises a redundant pad for the pad, wherein the redundant pad is disposed on the top surface.

13. The multichip device according to any of claims 8 to 12, wherein the interposer (52) comprises a redundant pad for the pad.

14. A method of detecting integrity in a multichip device, the method comprising:
providing a signal to an edge integrity detection structure (163A, 163B) on each of a plurality of die (100, 101A, 101B) coupled to an interposer (52);
receiving a signal from at least one of integrity edge integrity detection structure at a pad on the interposer (52); and
determining the integrity using the signal received at the pad.

15. The method according to claim 14, comprising at least one of the following features:
wherein the edge integrity detection structure (163A, 163B) comprises a conductive trace about a perimeter of the respective die (100, 101A, 101B);
further comprising:
providing a signal to an edge integrity detection structure on the interposer (52); and
receiving a signal from the edge integrity detection structure on the interposer (52).
